Europäisches Patentamt

European Patent Office

Office européen des brevets

(19)

(11) Veröffentlichungsnummer: **0 283 588 B1**

(12)

# EUROPÄISCHE PATENTSCHRIFT

(45) Veröffentlichungstag der Patentschrift: **06.10.93**

(21) Anmeldenummer: **87119302.5**

(22) Anmeldetag: **29.12.87**

(51) Int. Cl.5: **H01L 29/60**, H01L 29/10, H01L 29/74, H01L 29/36

(54) **Steuerbares Leistungs-Halbleiterbauelement.**

(30) Priorität: **24.02.87 CH 691/87**

(43) Veröffentlichungstag der Anmeldung:
**28.09.88 Patentblatt 88/39**

(45) Bekanntmachung des Hinweises auf die
Patenterteilung:
**06.10.93 Patentblatt 93/40**

(84) Benannte Vertragsstaaten:
**CH DE FR GB IT LI NL SE**

(56) Entgegenhaltungen:
**EP-A- 0 008 535**
**DE-A- 1 589 560**
**DE-A- 3 509 745**

**PATENT ABSTRACTS OF JAPAN, Band 8, Nr. 213 (E-269)(1650), 28. September 1984 & JP-A-59 99769**

**PATENT ABSTRACTS OF JAPAN, Band 7, Nr. 52 (E-162)(1197), 2. März 1983 & JP-A-57 201 978**

(73) Patentinhaber: **BBC Brown Boveri AG**
**Haselstrasse**
**CH-5401 Baden(CH)**

(72) Erfinder: **Jaecklin, André, Dr.**
**Geissbergstrasse 55**
**CH-5400 Ennetbaden(CH)**
Erfinder: **Roggwiller, Peter, Dr.**
**Püntstrasse 16**
**CH-8173 Riedt-Neerach(CH)**
Erfinder: **Veitz, Rudolf**
**Im Tobelacher 11**
**CH-5406 Baden(CH)**
Erfinder: **Vlasak, Thomas**
**Adelmatt 336**
**CH-5242 Birr(CH)**

**Beschreibung**

TECHNISCHES GEBIET

Die Erfindung bezieht sich auf das Gebiet der Halbleiterbauelemente. Sie betrifft insbesondere ein steuerbares Leistungs-Halbleiterbauelement nach dem Oberbegriff des ersten Anspruchs.

STAND DER TECHNIK

Ein solches Leistungs-Halbleiterbauelement ist beispielsweise aus der DE-A1-35 09 745 bekannt.

Steuerbare Leistungs-Halbeleiterbauelemente in der Form von über das Gate abschaltbaren (GTO = Gate Turn Off) Thyristoren erlangen in der Leistungselektronik wegen ihrer vereinfachten Ansteuerung zunehmend an Bedeutung.

Derartige GTO-Thyristoren für hohe Schaltleistungen bestehen typischerweise aus einer grossen Zahl (100 ... > 1000) von Einzelelementen, d.h. einzelnen, unabhängig voneinander angesteuerten Thyristoren oder Segmenten, die nebeneinander angeordnet sind und im Parallelbetrieb arbeiten.

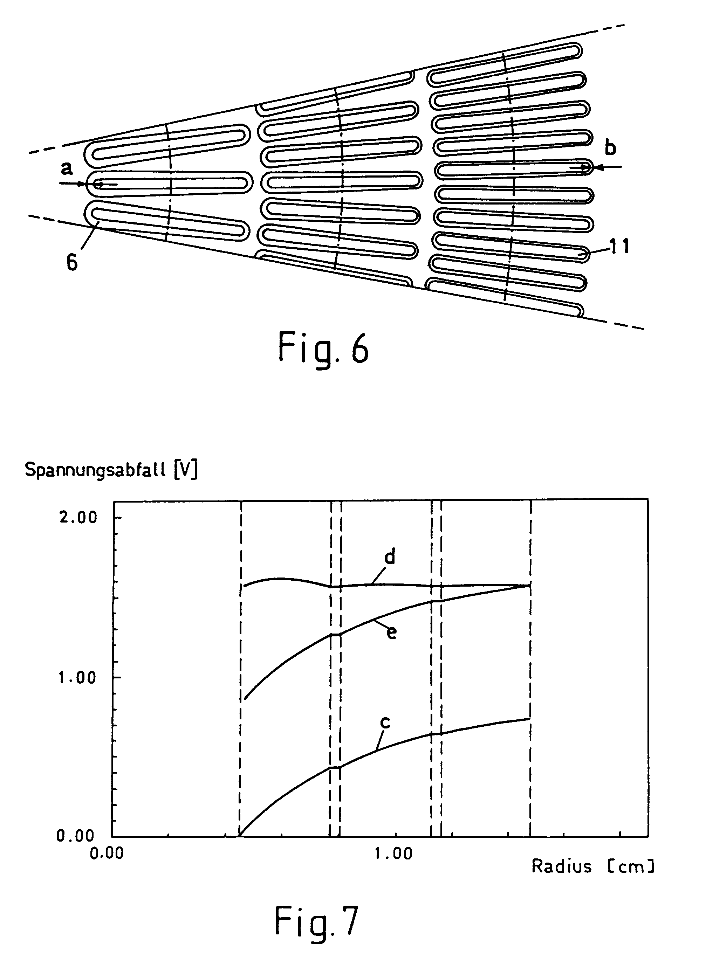

Die Stromtragfähigkeit des Gesamt-Bauelements wird sehr stark vom unterschiedlichen Verhalten der Einzelelemente bestimmt. So ist es insbesondere bekannt, dass die Belastbarkeit eines elementaren Einzelthyristors mehr als eine Zehnerpotenz höher sein kann als die durchschnittliche Belastbarkeit eines grösseren Kollektivs von Einzelelementen (siehe z.B. Fig. 7 in dem Artikel von T. Nagano et al. "A snubber-less GTO"; Power Electronics Specialists Conf., June 1982, Cambridge/Mass. USA).

Der maximale Abschaltstrom eines GTO gegebener Grösse hängt dabei einerseits von einer Streuung der Halbleitereigenschaften auf dem grossflächigen Si-Substrat ab. Eine möglichst geringe Streuung und damit ein maximierter Abschaltstrom kann in dieser Hinsicht durch eine sorgfältige Prozessführung, z.B. unter Verwendung von Bestrahlungsprozessen für Dotierung und Lebensdauereinstellung, erreicht werden (siehe bei A. Jaecklin und B. Adam, "Gate turn-off thyristors with near-perfect technology", Int. Electron Devices Meeting, Los Angeles, Dec. 1986).

Andererseits ist die Verteilung des Zündstromes zu allen Einzelthyristoren eines GTO-Bauelements aus geometrischen Gründen ungleichmässig, weil sich bei Einzelelementen mit unterschiedlichem Abstand zum Steuer- bzw. Zündanschluss ein unterschiedlich grosser Widerstand in den als zusammenhängende Metallisierungsschicht ausgeführten Zuleitungen ergibt.

Es ist nun in der DE-PS 31 34 074 bei einem GTO-Thyristor mit in konzentrischen Ringen angeordneten Einzelelementen vorgeschlagen worden, die besagten geometrisch bedingten Ungleichmässigkeiten bei der Ansteuerung dadurch zu beseitigen, dass der Steuerstrom über ein ringförmiges, zwischen den konzentrischen Ringen der Einzelelemente verlaufendes und niederohmiges Verbindungsglied zugeführt wird. Dieses Verbindungsglied ist in eine Verbundelektrodenplatte eingelassen, welche das Bauelement kontaktiert und mit erheblichem Aufwand und grosser Genauigkeit angefertigt werden muss.

Seine Wirksamkeit ist ausserdem hinfällig, sobald mehr als zwei konzentrische Ringe von Einzelelementen vorhanden sind.

Darüber hinaus bietet diese Art der Lösung auch keine Möglichkeit, die ungleiche Steuerstromverteilung längs eines Einzelelementes selbst zu beseitigen.

Ein anderer Lösungsweg wird nun in der DE-A1-35 09 745 beschritten: Der Wafer wird in eine Mehrzahl von Flächen aufgeteilt, welche unterschiedliche Träger-Lebensdauern aufweisen. Die Träger-Lebensdauer ist je länger je näher die Fläche zum gemeinsamen Gate-Zuführungspunkt angeordnet ist. Durch diese Strukturierung können überschüssige Ladungsträger während dem Abschalten des GTO auch in Flächen, welche vom Gate-Zuführungspunkt entfernt sind, verschwinden. Dadurch erhält man eine Verbesserung der AN-AUS-Charakteristik.

DARSTELLUNG DER ERFINDUNG

Der Erfindung liegt die Aufgabe zugrunde, ein steuerbares Leistungs-Halbleiterbauelement zu schaffen, das durch gleichmässige Ansteuerung der Einzelelemente höhere Ströme zu steuern vermag, ohne aufwendig in der Herstellung zu sein.

Die Aufgabe wird bei einem Leistungs-Halbleiterbauelement der eingangs genannten Art durch die Gesamtheit der Merkmale des ersten Anspruch gelöst.

Während also bei den bisher bekannten Lösungen durch eine geeignete geometrische Anordnung unterschiedliche Leitungswiderstände von vornherein vermieden werden sollen, oder die AN-AUS Charakteristik durch Flächen unterschiedlicher Träger-Lebensdauer verbessert wird, besteht der Kern der Erfindung darin, die unterschiedlichen Leitungswiderstände bewusst in Kauf zu nehmen, aber an Ort und Stelle, auf dem Halbleitersubstrat bei den jeweiligen Einzelelementen zu kompensieren. Dies wird dadurch erreicht, dass der Abstand des Randes der Steuerkontakt-Metallisierung zum zugehörigen fingerartigen Bereich des n-Emitters eingestellt wird.

Auf diese Weise können weiterhin die üblichen Kontaktierungsverfahren verwendet werden, da sich die Kompensationsmassnahmen auf eine Modifizierung des Halbleitersubstrats selbst beschränken.

Gemäss einer bevorzugten Ausführungsform der Erfindung weist das Leistungs-Halbleiterbauelement die Struktur eines GTO auf.

Weitere Ausgestaltungen der Erfindung ergeben sich aus den Unteransprüchen.

KURZE BESCHREIBUNG DER ZEICHNUNG

Die Erfindung soll nachfolgend im Zusammenhang mit der Zeichnung anhand von Ausführungsbeispielen näher erläutert wreden. Es zeigen:

Fig. 1 ausschnittweise den Aufbau eines Einzelelementes eines GTO-Thyristors mit zugehörigem Ersatzschaltbild des Steuerkreises;

Fig. 2 die bekannte Anordnung der fingerartigen Einzelelemente eines GTO-Thyristors in konzentrischen Ringen auf der Kathodenseite;

Fig. 3 das zu einer Anordnung gemäss Fig. 2 gehörende Ersatzschaltbild der Steuerkreise;

Fig. 4 eine experimentell ermittelte Strom-Spannungs-Kennlinie für das Gate eines GTO-Thyristors;

Fig. 5 am Querschnitt eines GTO-Einzelelements die Massnahmen gemäss verschiedener Ausführungsbeispiele der Erfindung zur Kompensation unterschiedlicher Leitungswiderstände;

Fig. 6 einen sektorartigen Ausschnitt der kathodenseitigen Fläche eines GTO nach der Erfindung, bei welchen die Einzelelemente mit Isolierschichten variierender Breite umgeben sind, und

Fig. 7 berechnete Kurven des radialen Spannungsabfalls für einen GTO nach dem Stand der Technik (c) und zwei Ausführungsformen eines GTO nach der Erfindung (d, e).

WEGE ZUR AUSFÜHRUNG DER ERFINDUNG

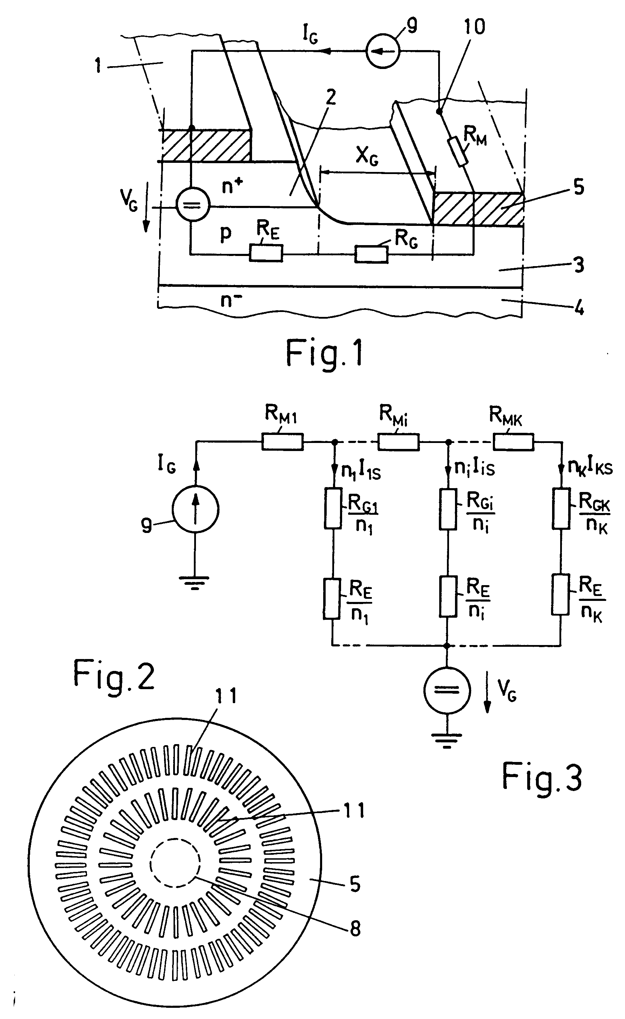

In Fig. 1 ist in perspektivischer Sicht ausschnittweise der Aufbau eines GTO-Thyristor-Elements dargestellt. Von der zwischen einer Anode und einer Kathode angeordneten Vier-Schichtenfolge sind hier der Uebersichtlichkeit halber die oberen drei Schichten, nämlich eine $n^-$-dotierte n-Basis 4, eine p-dotierte p-Basis 3 und ein $n^+$-dotierter n-Emitter 2, gezeigt.

Der n-Emitter 2 ist in seiner lateralen Ausdehnung auf einen bestimmten Bereich begrenzt und umgeben von der an die Oberfläche tretenden p-Basis 3. Der n-Emitter 2 und die p-Basis 3 sind mit einem Kathodenkontakt 1 bzw. Gatekontakt 5 in Form einer dünnen Metallisierung versehen. Der Gatekontakt 5 ist dabei auf den Teilbereich beschränkt, in dem die p-Basis 3 an die Oberfläche tritt.

Kathodenkontakt 1, n-Emitter 2, p-Basis 3 und Gatekontakt 5 bilden bei entsprechender äusserer Verbindung zwischen den beiden Kontakten den Zünd- bzw. Löschkreis des GTO-Elements, über den der Thyristor sowohl ein- als auch abgeschaltet wird.

Während des Ausschaltvorgangs, bei dem im Löschkreis erhebliche Ströme fliessen, lässt sich dieser Löschkreis durch ein einfaches, in Fig. 1 eingezeichnetes, ohmsches Ersatzschaltbild beschreiben. In diesem Ersatzschaltbild treibt eine äussere Stromquelle 9 einen Gatestrom $I_G$ durch eine Serienschaltung von drei Widerständen, einem Metallisierungs-Widerstand $R_M$, welcher den ohmschen Widerstand des Gatekontaktes parallel zur Oberfläche umfasst, einem Gategraben-Widerstand $R_G$, welcher den Widerstand in der p-Basis 3 vom Gatekontakt 5 zum Bereich des n-Emitters 2 umfasst (mit einem Gateabstand $X_G$), und einem Emitter-Widerstand $R_E$, welcher den Widerstand der p-Basis 3 unterhalb des n-Emitters 2 einschliesst. Ausserdem wird durch den bereits fliessenden Anodenstrom am Uebergang zwischen n-Emitter 2 und p-Basis 3 eine Gatespannung $V_G$ eingeprägt.

Es ist anhand der Darstellung aus Fig. 1 unmittelbar einsichtig, dass die Grösse des Metallisierungs-Widerstands $R_M$ davon abhängt, an welcher Stelle des Bauelements der Gatestrom $I_G$ in den Gatekontakt 5 eingespiesen wird, d.h. an welcher Stelle sich der Einspeisungspunkt 10 befindet: Je weiter die Wege des Gatestroms $I_G$ durch die Metallisierung des Gatekontaktes 5 sind, bevor er im Halbleiterinnern wirksam wird, umso grösser ist der Metallisierungs-Widerstand $R_M$.

Hieraus ergeben sich bereits bei einem einzelnen GTO-Element Ungleichverteilungen des Gatestroms $I_G$ längs des Elements. Besonders gravierend werden diese Ungleichverteilungen jedoch dann, wenn bei einem Hochleistungs-GTO auf einer grösseren Substratfläche eine Vielzahl von Einzelelementen verteilt ist, welche ihren Gatestrom von einem gemeinsamen Einspeisungspunkt aus beziehen.

Die kathodenseitige Ansicht eines solchen grossflächigen GTO-Thyristors ist in Fig. 2 wiedergegeben. Bei diesem Bauelement ist auf der runden Substratscheibe eine Vielzahl von Einzelelementen 11 in zwei konzentrischen Ringen angeordnet. Die Einzelelemente 11 sind allseitig von dem zusammenhängenden, aus einer einzigen Metallisierungsschicht bestehenden Gatekontakt 5 umgeben, der im Zentrum der Scheibe mit einem (gestrichelt eingezeichneten) Gateanschluss 8 kontaktiert wird.

Vom zentralen Gateanschluss 8 aus, welcher als Einspeisungspunkt für den Gatestrom dient, muss dieser Gatestrom zu den Einzelelementen des äusseren Rings längere Wege in der Metallisierungsschicht des Gatekontakts 5 zurücklegen als zu den näherliegenden Einzelelementen des inneren Rings.

Dieser Umstand findet seinen Ausdruck in dem in Fig. 3 dargestellten Ersatzschaltbild der Löschkreise für einen GTO-Thyristor entsprechend Fig. 2 mit im allgemeinen Fall k verschiedenen konzentrischen Ringen aus Einzelelementen. Der Gatestrom $I_G$ aus der äusseren Stromquelle 9 fliesst durch einen ersten Metallisierungs-Widerstand $R_{M1}$, welcher den inneren Widerstand der Metallisierung zwischen dem Gateanschluss und dem ersten, inneren Ring charakterisiert, und verzweigt sich dann, wobei der eine Anteil durch die $n_1$ parallelgeschalteten Einzelelemente des ersten Rings mit ihren als gleich vorausgesetzten Gategraben-Widerständen $R_{G1}$ und Emitter-Widerständen $R_{E1}$ zur Kathode gelangt (mit einer Gesamtstärke von $n_1 \cdot I_{1S}$; $I_{1S}$ = Strom durch ein Einzelelement bzw. Segment im ersten Ring).

Der andere Anteil durchläuft nach und nach weitere Metallisierungs-Widerstände $R_{M2}$, ..., $R_{Mi}$, ..., $R_{MK}$, die jeweils der Metallisierung zwischen benachbarten Ringen zugeordnet sind. Von ihm zweigt für jeden weiteren Ring der Nummern 2, ..., i, ..., k ein entsprechender Strom $n_2 \cdot I_{2S}$, ..., $n_i \cdot I_{iS}$, ..., $n_k \cdot I_{kS}$ ab, der sich aus den zugehörigen Zahlen $n_2$, ..., $n_i$, ..., $n_k$ der Einzelelemente ergibt.

Die insgesamt

$$\sum_{i=1}^{k} n_i$$

Einzelelemente des generalisierten GTO sind also in k verschiedenen konzentrischen Ringen angeordnet, wobei die Gategraben-Widerstände $R_{Gi}$ und Emitter-Widerstände $R_{Ei}$ für alle $n_i$ Einzelelemente eines Rings gleich sein sollen.

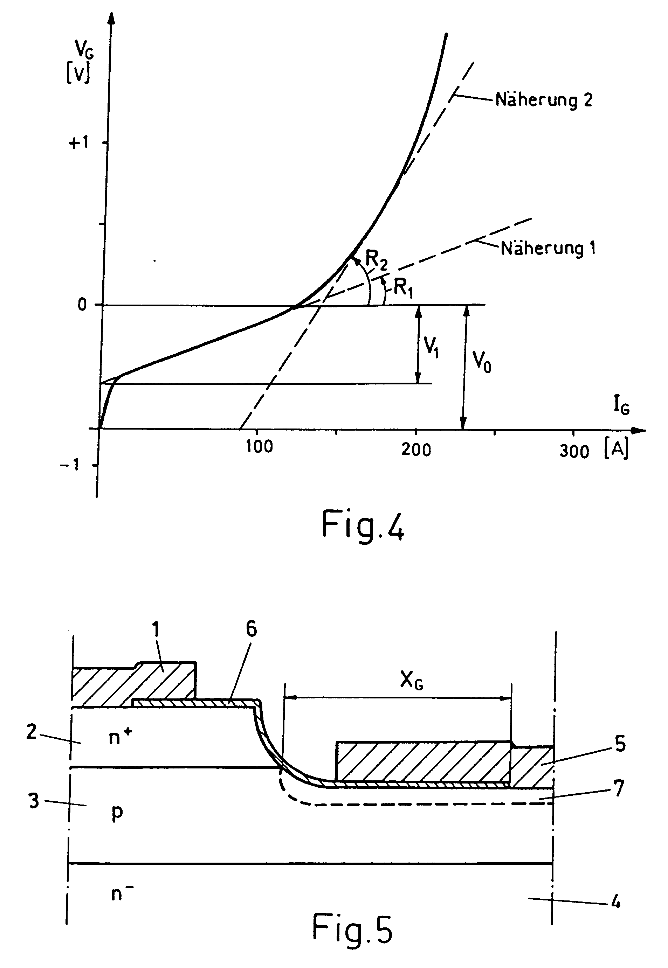

In Fig. 4 ist nun eine experimentell ermittelte Strom-Spannungs-Kennlinie für den Gatekreis eines solchen GTO dargestellt, die als Verifikation des in Fig. 3 angegebenen Modells betrachtet werden kann.

Gemäss einem bevorzugten Ausführungsbeispiel der Erfindung werden die Gategraben-Widerstände $R_{Gi}$ und Emitter-Widerstände $R_{Ei}$ nun so bemessen, dass die Unterschiede in den Spannungsabfällen an der Metallisierung kompensiert werden. Dadurch kann bei vorgegebener Metallisierung eine exakt homogene Verteilung der Steuerströme durch sämtliche Einzelelemente bzw. Segmente erzwungen werden. Diese Massnahme hat einerseits eine beträchtliche Erhöhung des Ausschaltstroms des ganzen Einzelelemente-Kollektivs zur Folge. Andererseits resultiert daraus eine wesentliche Erhöhung der Ausbeute bei der Serienherstellung, weil der Einfluss der Herstellungstoleranzen auf die Funktionstüchtigkeit der Bauelemente verringert wird.

Ein numerischer Vergleich der experimentell bestimmten Widerstandsgeraden in der $V_G(I_G)$-Kennlinie der Fig. 4 mit dem Ersatzschaltbild aus Fig. 3 zeigt, dass im ersten Teil des Abschaltvorganges ($V_G \lesssim 0$) für den dortigen Widerstand $R_1$ - (Fig. 4; Näherung 1) gilt:

$$(1) \qquad R_1 = R_{tot} \ (R_{Ei} = 0)$$

Diese Beziehung besagt, dass mit guter Näherung der Steuerstrom anfänglich, d.h. bei voll mit Ladungsträgern überschwemmter p-Basis 3 unterhalb des n-Emitters 4 nur durch die Gategraben-Widerstände $R_{Gi}$ und die Metallisierungs-Widerstände $R_{Mi}$ bestimmt wird ($R_{tot}$ = Gesamtwiderstand).

Die Kompensation des Metallisierungs-Widerstandes $R_{M2}$ kann in diesem Fall also durch entsprechende Wahl der $R_{Gi}$ alleine erreicht werden ($R_{Ei} \simeq 0$).

In einer späteren Phase ($V_G \gtrsim 0$; Näherung 2) wächst der wirksame Widerstand im Gatekreis, weil dort die Emitter-Widerstände $R_{Ei}$ nicht länger vernachlässigt werden können. Sofern jedoch alle n-Emitter-Bereiche der Einzelelemente geometrisch gleich sind, bestehen keine Unterschiede zwischen den Emitter-Widerständen $R_{Ei}$ der verschiedenen Ringe. Die Stromverteilung bleibt dann auch in dieser Phase homogen, sofern eine Kompensation durch die geeignete Wahl der $R_{Gi}$ vorgenommen worden ist. Selbst verbleibende Unterschiede zwischen den Strömen der Einzelelemente werden durch die hinzukommenden Emitter-Widerstände $R_{Ei}$ noch verringert.

Im einfachsten Fall eines GTO mit zwei konzentrischen Ringen (k = 2) errechnet sich für verschwindenden Emitter-Widerstand $R_{Ei}$ (=0) die Kompensationsbedingung gemäss Fig. 3 ($I_{1S} = I_{2S}$) zu:

$$(2) \qquad R_{G2} = R_{G1} - n_2 \, R_{M2}$$

In analoger Weise lassen sich Kompensationsbedingungen für grössere Zahlen von Ringen berechnen. Falls an Stelle des sogenannten "Zentralgate" (Gateanschluss 8 im Zentrum der Ringe) ein Ringgate (wie in der DE-PS 31 34 074) oder eine andere Art der Ansteuerung gewählt wird, kann das Ersatzschaltbild gemäss Fig. 3 leicht entsprechend modifiziert werden.

Eine weitere Massnahme, um die Struktur möglichst unempfindlich gegenüber den unvermeidbaren Herstellungstoleranzen zu gestalten, besteht im übrigen darin, die Gategraben-Widerstände $R_{Gi}$ möglichst gross zu wählen (Prinzip des Gate-Ballastwiderstands). Gleichermassen kann eine nur teilweise Kompensation der Metallisierungs-Widerstände bereits eine erhebliche Verbesserung des Bauelements mit sich bringen.

Darüber hinaus kann die beschriebene Art der Kompensation nicht nur zwischen verschiedenen Einzelelementen, sondern auch innerhalb eines Einzelelements selbst eingesetzt werden. Da nämlich der Widerstand der Gatemetallisierung längs eines Segments bzw. Einzelelements zunimmt mit dem Abstand vom Gateanschluss (vgl. Fig. 1), ist es denkbar, dass dieser Effekt dahingehend berücksichtigt wird, dass mit der Beziehung (2) der Gategraben-Widerstand $R_{Gi}$ kontinuierlich längs des Einzelelementes eingestellt wird.

Für die technologische Realisierung der individuellen Einstellung des Gategraben-Widerstandes $R_{Gi}$ kommen verschiedene Methoden in Betracht, die anhand der Fig. 5 im folgenden erläutert werden sollen.

Generell wird zur Kontaktierung der den Gategraben-Widerstand $R_{Gi}$ bildenden p-Basis 3 die Schicht des n-Emitters lokalisiert, d.h. auf bestimmte z.B. fingerartige Bereiche begrenzt. Dies geschieht entweder durch lokale Diffusion des n-Emitters (planare Variante) oder durch entsprechendes Abätzen einer zunächst homogenen $n^+$-dotierten Schicht (Ergebnis ist dann die Struktur gemäss Fig. 1, 5), oder durch eine Kombination beider Verfahren.

Eine mögliche Massnahme zur Aenderung des jeweiligen Widerstands in der p-Basis 3, speziell des Gategraben-Widerstands $R_{Gi}$ besteht nun darin, den Abstand des Randes der Gatekontakt-Metallisierung zum zugehörigen fingerartigen Bereich des n-Emitters 2, den Gateabstand $X_G$ (Fig. 1) zu ändern. Dies kann beispielsweise durch eine entsprechende Metallisierungs-Aetzmaske erfolgen.

Günstiger ist die in Fig. 5 dargestellte Lösung, bei der zur Aenderung des Gategraben-Widerstands $R_{Gi}$ bei gleichbleibendem Abstand des Randes der Gatekontakt-Metallisierung zum zugehörigen fingerartigen Bereich des n-Emitters 2 der elektrisch wirksame Abstand (Gateabstand $X_G$ in Fig. 5) durch eine genügend dicke Isolationsschicht 6 geändert wird, die vom n-Emitter 2 her unter die Metallisierung greift und die Metallisierung bis zu einer entsprechenden Entfernung (Gateabstand $X_G$) von der darunterliegenden p-Basis 3 isoliert.

In diesem Fall darf nämlich die Breite der Metallisierungsschicht gross sein, so dass als parasitärer Widerstand nur ein geringer Metallisierungs-Widerstand $R_{Mi}$ anfällt. Technisch lässt sich dieser Weg z.B. sehr einfach durch eine Oxidschicht

($SiO_2$) lösen, wie sie während der verschiedenen Herstellungsprozesse ohnehin entsteht.

Für den Fall eines GTO mit 3 konzentrischen Ringen von Einzelelementen 11 ist diese Art der Kompensation durch eine Isolationsschicht 6 beispielhaft in Fig. 6 dargestellt.

Die Einzelelemente 11 sind hier ( die Gatemetallisierung ist nicht gezeigt) jeweils von Isolationsschichten 6 umgeben, deren Breite in radialer Richtung, ausgehend vom Zentralgate, von einer grössten Breite a bis zu einer kleinsten Breite b abnimmt.

Die Werte von a und b können z.B. etwa 150 Mikrometer und 50 Mikrometer betragen, was einem Variationsverhältnis von 3 : 1 entspricht.

Eine deutliche Verbesserung in der Kompensation erhält man jedoch auch bereits, wenn im Sinne des bereits erwähnten Prinzips des Gate-Ballastwiderstandes alle Einzelelemente 11 mit einer Isolationsschicht 6 umgeben werden, die überall dieselbe Breite b (z.B. 50 Mikrometer) aufweist. Entscheidend für die Verbesserung ist dabei, dass die Isolationsschicht so breit gemacht wird, dass die Gategraben-Widerstände $R_{Gi}$ deutlich grösser sind, als die Metallisierungs-Widerstände $R_{Mi}$.

Wie gross die Verbesserungen gegenüber dem Stand der Technik sind, zeigen die in Fig. 7 wiedergegebenen Resultate einer Modellrechnung, bei der die Kurven des Spannungsabfalls über dem Radius für eine Struktur gemäss Fig. 6 ohne Isolationsschicht (Kurve c), mit einer Isolationsschicht konstanter Breite (Kurve e), und mit einer Isolationsschicht variierender Breite (Kurve d) berechnet worden sind.

Wie zu erwarten ist, liegen die gleichmässigsten Verhältnisse bei einer Isolationsschicht mit variierender Breite gemäss Fig. 6 vor (Kurve d).

Aber auch bei konstanter Breite der Isolationsschicht (z.B. gleich 50 Mikrometer) werden die Unterschiede zwischen dem inneren und dem äusseren Elementring bereits deutlich verringert (Kurve e).

Dagegen sind diese Unterschiede ohne Kompensation (Kurve c) sehr viel grösser.

Es ist weiterhin vorteilhaft, zum Erzielen eines grossen Variationsbereiches auch die Grösse des für den Gategraben-Widerstand $R_{Gi}$ massgeblichen Schichtwiderstands der p-Basis 3 für unterschiedliche Einzelelemente unterschiedlich einzustellen.

Zu diesem Zweck kann die p-Basis 3 in den Bereichen, in denen sie an die Oberfläche tritt, z.B. durch unterschiedliches Aetzen, unterschiedlich dick ausgebildet werden. Da es jedoch schwierig ist, für die Aetztiefe geringe Toleranzen einzuhalten, kann zur Ausbildung eines unterschiedlichen Schichtwiderstandes auch ein unterschiedliches Dotierungsprofil in der p-Basis 3 herangezogen werden. Insbesondere kann zu diesem Zweck, wie in Fig. 5 gestrichelt eingezeichnet, eine stärker dotierte Zusatzschicht 7 (z.B. nach der Aetzung) in den Bereichen der p-Basis 3, in denen sie an die Oberfläche tritt, eingebracht werden.

Indem nun in der beschriebenen Weise über den Bereich des Bauelements der Widerstand der p-Basis 3, insbesondere der Gategraben-Widerstand $R_{Gi}$ kompensierend eingestellt wird, erhält man ein Bauelement mit deutlich verbesserten elektrischen Eigenschaften.

Es versteht sich dabei von selbst, dass die Erfindung sich nicht auf GTO-Thyristoren der gewählten Beispiele beschränkt, sondern bei allen Leistungs-Halbleiterbauelementen mit flächig verteilten Segmenten angewendet werden kann.

**Patentansprüche**

1. Steuerbares Leistungs-Halbleiterbauelement, bei dem

   a) in einem Halbleitersubstrat zwischen einer Anode und einer Kathode übereinander ein p-Emitter, eine n-Basis (4), eine p-Basis (3) und ein n-Emitter (2) angeordnet sind;

   b) eine Steuerelektrode zur Steuerung des Bauelements vorgesehen ist;

   c) das Bauelement unterteilt ist in eine Mehrzahl nebeneinander angeordneter, parallelgeschalteter Einzelelemente (11);

   d) die Einzelelemente (11) durch fingerartige Bereiche des n-Emitters (2) gebildet werden, welche von der an die Oberfläche tretenden p-Basis (3) umgeben sind;

   e) jedem Einzelelement (11) ein Steuerkontakt zugeordnet ist, welcher durch eine auf die an die Oberfläche tretende p-Basis (3) aufgebrachte Metallisierung gebildet wird;

   f) die Steuerkontakte der Einzelelemente (11) mit einem gemeinsamen Steueranschluss verbunden sind und zusammen die Steuerelektrode bilden ;

   g) auf dem Halbleitersubstrat bei den Einzelelementen (11) Mittel vorgesehen sind, um unterschiedliche Leitungswiderstände zwischen dem jeweiligen Steuerkontakt und dem Steueranschluss zu kompensieren; dadurch gekennzeichnet, dass

   h) die Mittel zur Kompensation der Unterschiede in den Leitungswiderständen einen sich über die Fläche des Bauelementes ändernden Widerstand in der p-Basis (3) zwischen dem jeweiligen Steuerkontakt (5) und dem fingerartigen Bereich des n-Emitters (2) umfassen, und

   i) zur Einstellung des jeweiligen Widerstands in der p-Basis (3) der Abstand des Randes der Steuerkontakt-Metallisierung zum zugehörigen fingerartigen Bereich des n-Emitters (2) eingestellt wird.

2. Steuerbares Leistungs-Halbleiterbauelement nach Anspruch 1, dadurch gekennzeichnet,

   a) dass das Bauelement die Struktur eines über ein Gate abschaltbaren Thyristors (GTO) hat, und

   b) das Gate den Steuerkontakten der Einzelelemente (11) bzw. der Steuerelektrode zugeordnet ist.

3. Steuerbares Leistungs-Halbleiterbauelement nach Anspruch 2, dadurch gekennzeichnet, dass

   (a) die Einzelelemente (11) radial in einer Mehrzahl konzentrischer Kreise angeordnet sind, und

   (b) der Steueranschluss in Form eines Gateanschlusses (8) im Zentrum dieser Kreise oder ringförmig zwischen diesen Kreisen angeordnet ist.

4. Steuerbares Leistungs-Halbleiterbauelement nach Anspruch 1 oder 3, dadurch gekennzeichnet, dass zur Einstellung des jeweiligen Widerstands in der p-Basis (3) bei gleichbleibendem Abstand des Randes der Gatekontakt-Metallisierung zum zugehörigen fingerartigen Bereich des n-Emitters (2) der elektrisch wirksame Abstand durch eine Isolationsschicht (6) eingestellt wird, die vom fingerartigen Bereich her unter die Metallisierung greift und die Metallisierung bis zu einer entsprechenden Entfernung von der darunterliegenden p-Basis (3) isoliert.

5. Steuerbares Leistungs-Halbleiterbauelement nach Anspruch 1 oder 4, dadurch gekennzeichnet, dass der Schichtwiderstand der p-Basis (3) für unterschiedliche Einzelelemente (11) unterschiedlich eingestellt ist, und/oder der Schichtwiderstand der p-Basis (3) längs eines Einzelelements (11) lokal variiert.

6. Steuerbares Leistungs-Halbleiterbauelement nach Anspruch 5, dadurch gekennzeichnet, dass zur Einstellung des unterschiedlichen Schichtwiderstandes die p-Basis (3) in den Bereichen, in denen sie an die Oberfläche tritt, unterschiedlich dick ist.

7. Steuerbares Leistungs-Halbleiterbauelement nach Anspruch 5, dadurch gekennzeichnet, dass zur Einstellung des unterschiedlichen Schichtwiderstandes die p-Basis (3) ein unterschiedliches Dotierungsprofil aufweist.

8. Steuerbares Leistungs-Halbleiterbauelement nach Anspruch 7, dadurch gekennzeichnet, dass zur Verringerung des Schichtwiderstandes in die p-Basis (3) in den Bereichen, in denen sie an die Oberfläche tritt, eine stärker dotierte Zusatzschicht (7) eingebracht ist.

## Claims

1. Controllable power semiconductor component, in which

   a) a p-type emitter, an n-type base (4), a p-type base (3) and an n-type emitter (2) are arranged above one another between an anode and a cathode in a semiconductor substrate;

   b) a control electrode is provided for controlling the component;

   c) the component is subdivided into a plurality of parallel-connected individual elements (11) disposed adjacently to one another;

   d) the individual elements (11) are formed by finger-like areas of the n-type emitter (2) which are surrounded by the p-type base (3) emerging on the surface;

   e) a control contact is allocated to each individual element (11) which control contact is formed by a metallisation applied to the p-type base (3) emerging on the surface;

   f) the control contacts of the individual elements (11) are connected to a common gate and, together, form the control electrode;

   g) means for compensating for the different line resistances between the respective control contact and the gate are provided at the individual elements (11) on the semi-conductor substrate,

   characterised in that

   h) the means for compensating for the differences in the line resistances comprise a resistance, which changes over the area of the component, in the p-type base (3) between the respective control contact (5) and the finger-like area of the n-type emitter (2) and

   i) the distance of the edge of the control-contact metallisation from the associated finger-like area of the n-type emitter (2) is adjusted for adjusting the respective resistance in the p-type base (3).

2. Controllable power semiconductor component according to Claim 1, characterised in that

   a) the component has the structure of the gate turn-off (GTO) thyristor and

   b) the gate is associated with the control contacts of the individual elements (11) or, respectively, the control electrode.

3. Controllable power semiconductor component according to Claim 2, characterised in that

   a) the individual elements (11) are radially disposed in a plurality of concentric circles and

   b) the gate is disposed at the centre of these circles or annularly between these circles in the form of a gate connection (8).

4. Controllable power semiconductor component according to Claim 1 or 3, characterised in that, for the purpose of adjusting the respective resistance in the p-type base (3) with a constant distance between the edge of the gate contact metallisation and the associated finger-like area of the n-type emitter (2), the electrically effective distance is adjusted by an insulation layer (6) which extends under the metallisation from the finger-like area and insulates the metallisation from the underlying p-type base (3) up to a corresponding distance.

5. Controllable power semiconductor component according to Claim 1 or 4, characterised in that the layer resistance of the p-type base (3) is adjusted differently for different individual elements (11), and/or the layer resistance of the p-type base (3) varies locally along an individual element (11).

6. Controllable power semiconductor component according to Claim 5, characterised in that, for the purpose of adjusting the different layer resistance, the p-type base (3) is of different thickness in the areas in which it emerges on the surface.

7. Controllable power semiconductor component according to Claim 5, characterised in that, for the purpose of adjusting the different layer resistance, the p-type base (3) exhibits a different doping profile.

8. Controllable power semiconductor component according to Claim 7, characterised in that, for the purpose of reducing the layer resistance, a more strongly doped additional layer (7) is inserted into the p-type base (3) in the areas in which it emerges on the surface.

## Revendications

1. Composant à semi-conducteur de puissance pouvant être commandé, pour lequel :

a) dans un substrat semi-conducteur, entre une anode et une cathode, sont disposés en superposition un émetteur P, une base N (4), une base P (3) et un émetteur N (2);

b) une électrode de commande est prévue pour commander le composant;

c) le composant est subdivisé en une pluralité d'éléments individuels (11) connectés en parallèle et disposés les uns à côté des autres;

d) les éléments individuels (11) sont formés par des domaines en forme de doigt de l'émetteur N (2), ces domaines étant entourés par la base P (3) apparaissant à la surface;

e) à chaque élément individuel (11) est associé un contact de commande qui est formé par une métallisation appliquée sur la base P (3) apparaissant à la surface;

f) les contacts de commande des éléments individuels (11) sont connectés à une connexion de commande commune et forment ensemble l'électrode de commande;

g) sur le substrat semi-conducteur, pour les éléments individuels (11), sont prévus des moyens destinés à compenser des résistances de conducteur différentes entre le contact de commande en question et la connexion de commande;

  caractérisé en ce que:

h) les moyens destinés à compenser les différences dans les résistances de conducteur comprennent une résistance dans la base P (3) qui se modifie sur la surface du composant et qui est disposée entre le contact de commande (5) en question et le domaine en forme de doigt de l'émetteur N (2), et

i) pour le réglage de la résistance en question dans la base P (3), on règle la distance entre le bord de la métallisation de contact de commande et le domaine en forme de doigt associé de l'émetteur N (2).

2.  Composant à semi-conducteur de puissance pouvant être commandé suivant la revendication 1, caractérisé en ce que :

    a) le composant a la structure d'un thyristor blocable par la gâchette (GTO), et

    b) la gâchette est associée aux contacts de commande des éléments individuels (11) ou de l'électrode de commande.

3.  Composant à semi-conducteur de puissance pouvant être commandé suivant la revendication 2, caractérisé en ce que :

    a) les éléments individuels (11) sont disposés radialement en plusieurs couronnes concentriques;

    b) la connexion de commande ayant la forme d'une connexion de gâchette (8) est disposée au centre de ces cercles ou à la forme d'un anneau placé entre ces cercles.

4.  Composant à semi-conducteur de puissance pouvant être commandé suivant la revendication 1 ou 3, caractérisé en ce que, pour le réglage de la résistance respective dans la base P (3), dans le cas d'une distance constante entre le bord de la métallisation de contact de gâchette et le domaine en forme de doigt associé de l'émetteur N (2), la distance électriquement efficace est réglée par une couche d'isolation (6) qui, à partir du domaine en forme de doigt, s'engage en dessous de la métallisation et isole la métallisation jusqu'à une distance correspondante de la base P (3) sous-jacente.

5.  Composant à semi-conducteur de puissance pouvant être commandé suivant la revendication 1 ou 4, caractérisé en ce que la résistance série de la base P (3) est réglée de manière différenciée pour différents éléments individuels (11) et/ou la résistance série de la base P (3) est modifiée localement le long d'un élément individuel (11).

6.  Composant à semi-conducteur de puissance pouvant être commandé suivant la revendication 5, caractérisé en ce que pour le réglage de la résistance série différenciée, la base P (3) dans les domaines dans lesquels elle apparaît à la surface, est d'une épaisseur différente.

7.  Composant à semi-conducteur de puissance pouvant être commandé suivant la revendication 5, caractérisé en ce que pour le réglage de la résistance série différenciée, la base P (3) présente un profil de dopage différent.

8.  Composant à semi-conducteur de puissance pouvant être commandé suivant la revendication 7, caractérisé en ce que pour diminuer la résistance série dans la base P (3) dans les domaines dans lesquels elle apparaît à la surface, une couche additionnelle fortement dopée (7) est prévue.

Fig.1

Fig.2

Fig.3

Fig.4

Fig.5

Fig. 6

Spannungsabfall [V]

Radius [cm]

Fig. 7